(19) Europäisches Patentamt / European Patent Office / Office européen des brevets

(11) **EP 4 691 758 A1**

(12) **EUROPEAN PATENT APPLICATION**
published in accordance with Art. 153(4) EPC

(43) Date of publication:
**11.02.2026 Bulletin 2026/07**

(21) Application number: **24779808.5**

(22) Date of filing: **21.03.2024**

(51) International Patent Classification (IPC):
*B32B 7/025* [(2019.01)]    *B32B 27/18* [(2006.01)]
*B32B 27/30* [(2006.01)]    *G02B 1/14* [(2015.01)]
*G02B 1/16* [(2015.01)]    *H10N 30/045* [(2023.01)]
*H10N 30/077* [(2023.01)]    *H10N 30/097* [(2023.01)]
*H10N 30/857* [(2023.01)]

(52) Cooperative Patent Classification (CPC):
**H10N 30/857; B32B 7/025; B32B 27/18;**
**B32B 27/30; G02B 1/14; G02B 1/16; H10N 30/02;**
**H10N 30/883;** H10N 30/045; H10N 30/098

(86) International application number:
**PCT/JP2024/010932**

(87) International publication number:
**WO 2024/203685 (03.10.2024 Gazette 2024/40)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **24.03.2023 JP 2023048031**

(71) Applicant: **Kureha Corporation**
**Chuo-ku**
**Tokyo 103-8552 (JP)**

(72) Inventor: **IMAJI, Makoto**
**Tokyo 103-8552 (JP)**

(74) Representative: **Hoefer & Partner Patentanwälte**
**mbB**
**Pilgersheimer Straße 20**
**81543 München (DE)**

(54) **MULTILAYER PIEZOELECTRIC BODY AND METHOD FOR PRODUCING SAME**

(57)    A laminated piezoelectric body includes a piezoelectric film containing a fluorine-based resin as a main component, an antistatic layer disposed on at least one surface of the piezoelectric film and having a thickness of 10 nm or more and 250 nm or less, and a hard coat layer disposed on the antistatic layer and having a maximum surface height Rz of 40 nm or more and 150 nm or less. The laminated piezoelectric body has a surface resistivity measured on the hard coat layer of $1.0 \times 10^6$ Ω/sq. or more and $1.0 \times 10^{12}$ Ω/sq. or less, a total light transmittance of 85% or more, and a piezoelectric constant $d_{33}$ of 7 pC/N or more and 40 pC/N or less.

## Description

### TECHNICAL FIELD

The present invention relates to a laminated piezoelectric body and a method for producing the same.

### BACKGROUND ART

A touch panel is attached to a display of an electronic device and is used for operating the electronic device. There are various types of touch panels, but a capacitive type is often adopted because it has a simple structure, can be produced at a low cost, and is relatively easy to scale up to a large size. In the capacitive type touch panel, signal processing is complicated, and thus, malfunction is likely to occur.

In general, a touch panel detects a two-dimensional position (position coordinates) on a surface of the touch panel when the surface of the touch panel is touched by a finger, a pen, or the like. In touch panel input, it is desirable that selection and execution are separated from each other to prevent input misrecognition. Specifically, selection is desirably performed by selecting a two-dimensional position on the touch surface and applying pressure to the touch surface. Accordingly, it has been studied to improve reliability by applying a pressure-sensitive sensor to a touch panel and further detecting the magnitude of applied pressure (for example, Patent Document 1).

As the pressure-sensitive sensor applied to the touch panel, application of a piezoelectric film that generates a voltage in response to applied pressure has been proposed. As the piezoelectric film, there is known a piezoelectric film containing a polymer material such as polylactic acid or a fluorine-based resin.

These piezoelectric films are excellent in transparency, but are likely to be charged by friction or vibration, and static electricity is likely to be generated. When static electricity is generated, foreign matter is likely to adhere to the piezoelectric film, which may deteriorate the quality. In addition, when the film surface is scratched in the process of handling the piezoelectric film, visibility is likely to be reduced when the film is used in a touch panel. Thus, a piezoelectric film having an antistatic property and scratch resistance is required.

For this, Patent Document 2 discloses a laminated piezoelectric body including a piezoelectric film containing polylactic acid and a surface layer disposed, the surface layer containing a conductive material (A) and a polymer (B). In this document, the surface layer is a hard coat layer having an antistatic property, and thus the laminated piezoelectric body has a favorable antistatic property and scratch resistance.

### CITATION LIST

#### PATENT DOCUMENT

Patent Document 1: JP 2010-26938 A
Patent Document 2: WO 2016/098597

### SUMMARY OF INVENTION

#### TECHNICAL PROBLEM

However, according to studies of the present inventors, the laminated piezoelectric body of Patent Document 2 has a problem that the surface of the hard coat layer has a poor sliding property, and when the laminated piezoelectric body is wound into a roll shape, for example, portions of the laminated piezoelectric body are in close contact with each other and sticking (blocking) is likely to occur. In addition, the piezoelectric film containing polylactic acid used in Patent Document 2 has a piezoelectric constant $d_{14}$ of 6.4 pC/N, which is low, and thus there is also a problem that it is difficult to obtain a sufficient piezoelectric effect.

In contrast, the present inventors have found a new problem that when an antistatic layer is formed on a piezoelectric film containing a fluorine-based resin having a high piezoelectric constant $d_{33}$ and a sufficient piezoelectric effect, coating irregularities occur in the obtained laminated piezoelectric body, which reduces visibility.

Accordingly, a laminated piezoelectric body that exhibits high piezoelectricity and has an anti-blocking property and an antistatic property without reducing visibility is desired.

The present invention has been made in view of the above circumstances, and an object thereof is to provide a laminated piezoelectric body having high piezoelectricity, an anti-blocking property, and an antistatic property without reducing visibility, and a method for producing the same.

## SOLUTION TO PROBLEM

[1] A laminated piezoelectric body, including: a piezoelectric film containing a fluorine-based resin as a main component; an antistatic layer disposed on at least one surface of the piezoelectric film and having a thickness of 10 nm or more and 250 nm or less; and a hard coat layer disposed on the antistatic layer and having a maximum surface height Rz of 40 nm or more and 150 nm or less, the laminated piezoelectric body having a surface resistivity of $1.0 \times 10^6 \, \Omega$/sq. or more and $1.0 \times 10^{12} \, \Omega$/sq. or less, the surface resistivity being measured on the hard coat layer, and the laminated piezoelectric body having a total light transmittance of 85% or more, and a piezoelectric constant $d_{33}$ of 7 pC/N or more and 40 pC/N or less.

[2] The laminated piezoelectric body according to [1], in which the fluorine-based resin is a polymer containing, as a main component, a structural unit derived from vinylidene fluoride.

[3] The laminated piezoelectric body according to [1] or [2], in which the fluorine-based resin is a vinylidene fluoride homopolymer.

[4] The laminated piezoelectric body according to any one of [1] to [3], in which the antistatic layer contains a carbon nanotube.

[5] The laminated piezoelectric body according to any one of [1] to [4], in which the hard coat layer has a thickness of 300 nm or more and 3000 nm or less.

[6] The laminated piezoelectric body according to any one of [1] to [5], in which the hard coat layer contains silica particles having an average particle size of 10 nm or more and 200 nm or less.

[7] A method for producing the laminated piezoelectric body described in any one of [1] to [5], the method including: preparing a piezoelectric film containing a fluorine-based resin as a main component and having a piezoelectric constant $d_{33}$ of 7 pC/N or more and 40 pC/N or less; applying an antistatic material onto at least one surface of the piezoelectric film to form an antistatic layer; and applying a curable composition onto the antistatic layer and then curing the curable composition to form a hard coat layer.

[8] The method for producing the laminated piezoelectric body according to [7], in which in the preparing of the piezoelectric film, a film containing a fluorine-based resin as a main component is formed by extrusion molding.

[9] The method for producing the laminated piezoelectric body according to [7] or [8], in which in the preparing of the piezoelectric film, a film containing a fluorine-based resin as a main component is stretched and then subjected to a polarization treatment.

[10] The method for producing the laminated piezoelectric body according to any one of [7] to [9], in which in the forming of the antistatic layer, the piezoelectric film onto which the antistatic material is applied is dried by a heat treatment at 100°C or higher and 150°C or lower.

## ADVANTAGEOUS EFFECTS OF INVENTION

According to the present invention, a laminated piezoelectric body having high piezoelectricity, an anti-blocking property, and an antistatic property without reducing visibility, and a method for producing the same can be provided.

## DESCRIPTION OF EMBODIMENTS

As described above, it has been newly found that in a laminated piezoelectric body having a piezoelectric film containing a fluorine-based resin as a main component, coating irregularities occur, which has not been a problem in a laminated piezoelectric body having a piezoelectric film containing polylactic acid.

According to the studies of the present inventors, the coating irregularities are caused by coating unevenness of the antistatic layer. It is presumable that the coating unevenness is caused by capturing fine irregularities on the surface of the piezoelectric film. It is presumable that irregularities on the surface of the piezoelectric film are formed in a process of performing a stretching treatment or a polarization treatment of a film containing a fluorine-based resin as a main component, the process allowing the piezoelectric film to exhibit a high piezoelectric effect (piezoelectric constant $d_{33}$). Specifically, it is presumable that the irregularities result from wrinkle generation on the surface of the piezoelectric film containing a fluorine-based resin, due to disturbance of the crystal structure caused by transition of a crystal of the fluorine-based resin from an $\alpha$-type to a $\beta$-type, or due to relaxation of a molecular chain accompanying the change in crystal structure, by the polarization treatment. On the other hand, it is presumable that, in the piezoelectric film containing polylactic acid, crystallinity is low and the polarization treatment is not performed, and thus wrinkle generation on the surface of the piezoelectric film is rare (no generation).

In contrast, in one embodiment of the present invention, the thickness of the antistatic layer disposed on the piezoelectric film containing a fluorine-based resin is set to be equal to or less than a predetermined value. When the antistatic layer is thickly applied, the antistatic layer is thickly applied to a concave portion of the piezoelectric film, and thus the coating irregularities of the antistatic layer in the laminated piezoelectric body become large. On the other hand, when the antistatic layer is thinly applied, thickness irregularities of the antistatic layer are reduced, and variation itself due to the irregularities of the surface of the piezoelectric film is also reduced, and thus the coating unevenness is less likely to occur. Accordingly, coating irregularities in the laminated piezoelectric body can be reduced, and the reduction in visibility can be suppressed.

In addition, when the antistatic layer and the hard coat layer having adjusted surface roughness (Rz) are laminated in such a manner that surface resistivity is equal to or less than a predetermined value, both the anti-blocking property and the antistatic property can be achieved at a high level.

Hereinafter, a laminated piezoelectric body according to an embodiment of the present invention and a method for producing the same will be specifically described.

1. Laminated Piezoelectric Body

The laminated piezoelectric body according to the present embodiment includes a piezoelectric film, an antistatic layer, and a hard coat layer.

1-1. Piezoelectric Film

The piezoelectric film is a film containing a fluorine-based resin as a main component, and has a piezoelectric constant $d_{33}$ adjusted to be 7 pC/N or more and 40 pC/N or less. When the piezoelectric constant $d_{33}$ of the piezoelectric film is 7 pC/N or more, an amount of charge to be generated by the piezoelectric effect is sufficient, and thus high pressure sensitivity is likely to be achieved. When the piezoelectric constant $d_{33}$ of the piezoelectric film is 40 pC/N or less, it is possible to further reduce irregularities of the film surface caused by, for example, the polarization treatment, and thus to reduce poor appearance. From the same viewpoint, the piezoelectric constant $d_{33}$ of the piezoelectric film is more preferably 10 pC/N or more and 35 pC/N or less, still more preferably 10 pC/N or more and 27 pC/N or less, and particularly preferably 10 pC/N or more and 24 pC/N or less.

The piezoelectric constant $d_{33}$ is one of indices indicating a polarization behavior when a certain pressure is applied. As the piezoelectric constant $d_{33}$ is larger, the degree of polarization caused upon application of a constant pressure becomes larger, and the density of electric charge becomes larger. Thus, the degree of charge accumulation in the piezoelectric film also becomes larger.

The piezoelectric constant $d_{33}$ of the piezoelectric film can be measured by measuring the piezoelectric constant $d_{33}$ in accordance with ISO 19622:2018, which is a test method for a piezoelectric constant $d_{33}$ of piezoelectric ceramics by a direct quasi-static method ($d_{33}$ meter method, Berlincourt method). To be specific, a sample of the piezoelectric film is clipped at 1.0 N, and a generated charge when a force of 0.15 N and 110 Hz is applied is read using a piezoelectric constant measuring device (for example, PiezoMeter System PM300, available from PIEZOTEST Pte Ltd.).

The piezoelectric constant $d_{33}$ of the piezoelectric film can be adjusted mainly by a type of the resin contained in the piezoelectric film and production conditions (conditions for the polarization treatment and the stretching treatment). For example, among fluorine-based resins, the piezoelectric constant $d_{33}$ of the piezoelectric film is likely to be increased as the resin includes more structural units derived from vinylidene fluoride. In addition, the piezoelectric constant $d_{33}$ of the piezoelectric film is likely to be increased by strengthening the polarization treatment or the stretching treatment.

As described above, the piezoelectric film contains a fluorine-based resin as a main component. The expression "containing a fluorine-based resin as a main component" means that a content of a resin having a fluorine-based resin as a structural unit (including the fluorine-based resin itself) is 50 mass% or more in the total mass of the resin constituting the piezoelectric film. The content of the fluorine-based resin is preferably 60 mass% or more, and more preferably 80 mass% or more. The upper limit of the content is not particularly limited, and may be 100 mass% or 90 mass% or less.

Among the fluorine-based resins, from the viewpoint of easily obtaining a high piezoelectric effect, the fluorine-based resin is preferably a polymer containing, as a main component, a structural unit derived from vinylidene fluoride.

The content of the structural unit derived from vinylidene fluoride contained as a main component in the polymer is preferably 50 mass% or more, more preferably 70 mass% or more, still more preferably 80 % or more, and particularly preferably 90 % or more, with respect to the total amount of structural units of the polymer. As the content is larger, a higher piezoelectric effect is more likely to be achieved. The upper limit of the content is not particularly limited, and may be 100 mass% or 90 mass% or less.

The polymer may further include a structural unit derived from a monomer copolymerizable with vinylidene fluoride as long as the effects of the present invention are not impaired. Examples of the monomer copolymerizable with vinylidene fluoride include fluorine-containing monomers, such as trifluoroethylene, tetrafluoroethylene, hexafluoropropylene, chlorotrifluoroethylene, and vinyl fluoride. Note that two or more types of these monomers may be contained.

Among them, a vinylidene fluoride homopolymer is preferable from the viewpoint of easily increasing the

piezoelectric constant $d_{33}$ of the piezoelectric film and enhancing sensitivity of a pressure-sensitive sensor to which the piezoelectric film is applied.

The piezoelectric film preferably has a thickness of, for example, 25 $\mu$m or more and 120 $\mu$m or less. When the thickness of the piezoelectric film is 25 $\mu$m or more, an amount of charge to be generated by a piezoelectric effect is further increased, and higher piezoelectricity is easily obtained. The thickness of the piezoelectric film is more preferably 30 $\mu$m or more and still more preferably 35 $\mu$m or more. When the thickness of the piezoelectric film is 120 $\mu$m or less, transparency of the piezoelectric film is less likely to be impaired. The thickness is more preferably 100 $\mu$m or less, and still more preferably 80 $\mu$m or less. From the same viewpoint, the thickness of the piezoelectric film is more preferably 35 $\mu$m or more and 80 $\mu$m or less.

1-2. Antistatic Layer

The antistatic layer has a function of preventing the laminated piezoelectric body from being charged. The antistatic layer is disposed on at least one surface of the piezoelectric film.

The surface resistivity of the antistatic layer is adjusted in such a manner that the surface resistivity measured on the hard coat layer is in a range described below. Accordingly, the surface resistivity of the antistatic layer is preferably lower than the surface resistivity measured on the hard coat layer, and specifically, is preferably $1.0 \times 10^4$ $\Omega$/sq. or more and $1.0 \times 10^9$ $\Omega$/sq. or less, and more preferably $1.0 \times 10^5$ $\Omega$/sq. or more and $1.0 \times 10^8$ /sq. or less. When the surface resistivity of the antistatic layer is $1.0 \times 10^9$ $\Omega$/sq. or less, the surface resistivity measured on the hard coat layer is easily lowered, and the antistatic property is easily sufficiently imparted. The surface resistivity can be measured in accordance with JIS K 6911 by, for example, using a known resistivity meter.

The surface resistivity can be adjusted by the thickness of the antistatic layer, and the type and the content of a conductive material contained in the antistatic layer. For example, when the thickness of the antistatic layer is increased, the surface resistivity is decreased. In addition, when the content of the conductive material is increased, the surface resistivity is decreased.

The antistatic layer contains a conductive material. In the present embodiment, the antistatic layer can contain a cured product of a curable composition containing a conductive material, a polymerizable compound, and a curing agent of any type.

The conductive material may be any material as long as the surface resistivity of the antistatic layer is in the above range, and may be an ion conductive type conductive material or an electron conductive type conductive material.

Examples of the ion conductive type conductive material include (a) cationic antistatic agents having a cationic group such as quaternary ammonium salts, pyridinium salts, and primary to tertiary amino groups; (b) anionic antistatic agents having an anionic group such as a sulfonate group, a sulfate ester group, a phosphate ester group, and a phosphonate group; (c) amino acid-based and amino sulfate-based amphoteric antistatic agents; and (d) amino alcohol-based, glycerin-based, and polyethylene glycol-based nonionic antistatic agents.

Examples of the electron conductive type conductive material include a conductive polymer and other conductive materials. Examples of the conductive polymer include polyacetylene or a derivative thereof, polythiophene or a derivative thereof, polypyrrole or a derivative thereof, and polyaniline or a derivative thereof. Among them, polythiophene or a derivative thereof is preferable from the viewpoint of having high transparency and exhibiting high conductivity. Examples of the conductive materials other than the conductive polymer include a carbon nanotube and graphene.

Among them, from the viewpoint of easily lowering the surface resistivity of the laminated piezoelectric body and hardly causing bleed-out, it is preferable to include an electron conductive type conductive material. Among the electron conductive type conductive materials, a carbon nanotube is more preferable from the viewpoint of further lowering the surface resistivity of the antistatic layer and thereby further lowering the surface resistivity measured on the hard coat layer.

The polymerizable compound may be a thermally polymerizable compound or a photopolymerizable compound, and examples thereof include an acrylic compound, an epoxy compound, an oxetane compound, a polyurethane compound, a polyimide resin, a melamine resin, a silicone compound, and vinyl acetate. For example, the same polymerizable compound as that for forming the hard coat layer described below may be used.

The thickness of the antistatic layer may be in any range as long as an antistatic property can be imparted, and is, for example, 10 nm or more and 250 nm or less. When the thickness of the antistatic layer is 10 nm or more, the surface resistivity of the antistatic layer can be further reduced, and thus the surface resistivity measured on the hard coat layer is also easily reduced, and a high antistatic property is easily obtained. When the thickness of the antistatic layer is 250 nm or less, coating unevenness due to irregularities on the surface of the piezoelectric film is less likely to occur, which can further suppress the occurrence of coating irregularities. From the same viewpoint, the thickness of the antistatic layer is more preferably 15 nm or more and 220 nm or less, still more preferably 20 nm or more and 190 nm or less, and particularly preferably 20 nm or more and 160 nm or less.

1-3. Hard Coat Layer

The hard coat layer has a function of increasing scratch resistance of the surface of the laminated piezoelectric body and increasing a sliding property to suppress blocking.

The hard coat layer may be a monolayer or include a plurality of layers. At least one hard coat layer is preferably disposed on the antistatic layer. In addition, at least one hard coat layer is preferably disposed on the outermost surface of the laminated piezoelectric body.

The hard coat layer preferably has appropriate surface roughness from the viewpoint of suppressing blocking. Specifically, a maximum height Rz of the surface of the hard coat layer is adjusted to be 40 nm or more and 150 nm or less. When Rz of the surface of the hard coat layer is 40 nm or more, the hard coat layer has a sufficient sliding property, and thus blocking between portions of the laminated piezoelectric body can be suppressed. When Rz of the surface of the hard coat layer is 150 nm or less, a reduction in transparency due to an increase in haze can be suppressed. From the same viewpoint, Rz of the surface of the hard coat layer is more preferably 40 nm or more and 100 nm or less, still more preferably 40 nm or more and 80 nm or less, and particularly preferably 40 nm or more and 60 nm or less.

Rz of the surface of the hard coat layer can be measured by a method in accordance with JIS B 0601-2013 using a surface roughness measuring instrument (for example, "SURFCOM 1500", available from TOKYO SEIMITSU CO., LTD.). Rz is measured at 10 random points in the hard coat layer in the width direction (TD direction) of the laminated piezoelectric body, and the average value thereof is calculated as Rz.

Rz of the surface of the hard coat layer can be adjusted by an average particle size of particles contained in the hard coat layer, or the like. For example, when the average particle size of the particles contained in the hard coat layer is increased, Rz is likely to increase.

The hard coat layer may be a resin layer containing particles. The resin layer containing particles is preferably obtained by curing a curable composition containing a polymerizable compound and particles from the viewpoint of increasing scratch resistance.

Polymerizable Compound

The polymerizable compound may be any of a monomer, an oligomer, and a polymer. The polymerizable compound may be a thermosetting compound or an ionizing radiation compound, but is preferably an ionizing radiation compound. The ionizing radiation may typically be ultraviolet light (UV) or an electron beam (EB).

The ionizing radiation compound is a compound having an ionizing radiation-curable functional group. Examples of the ionizing radiation-curable functional group include ethylenically unsaturated bond groups such as a (meth)acryloyl group, a vinyl group, and an allyl group, and ring-opening polymerizable groups such as an epoxy group and an oxetanyl group. Among them, a compound having an ethylenically unsaturated bond group is preferable, a compound having two or more ethylenically unsaturated bond groups is more preferable, and a polyfunctional (meth)acrylate-based compound is still more preferable.

Examples of a bifunctional (meth)acrylate-based monomer among the polyfunctional (meth)acrylate-based compounds include ethylene glycol di(meth) acrylate, bisphenol A tetraethoxy diacrylate, bisphenol A tetrapropoxy diacrylate, and 1,6-hexanediol diacrylate. Examples of the (meth)acrylate-based monomer having three or more functional groups include trimethylolpropane tri(meth)acrylate, pentaerythritol tri(meth)acrylate, pentaerythritol tetra(meth)acrylate, dipentaerythritol hexa(meth)acrylate, dipentaerythritol tetra(meth)acrylate, and isocyanuric acid-modified tri(meth)acrylate. The (meth)acrylate-based monomer may be one in which a part of the molecular skeleton is modified, or one modified with ethylene oxide, propylene oxide, caprolactone, isocyanuric acid, alkyl, cyclic alkyl, aromatic, bisphenol, or the like can also be used.

Examples of the polyfunctional (meth)acrylate-based oligomer include acrylate-based polymers such as urethane (meth)acrylate, epoxy (meth)acrylate, polyester (meth)acrylate, and polyether (meth)acrylate. Urethane (meth)acrylate is obtained, for example, by reacting a polyhydric alcohol and an organic diisocyanate with a hydroxy (meth)acrylate.

Polymerization Initiator

In a case where the ionizing radiation-curable compound is an ultraviolet light-curable compound, the curable composition preferably contains a photopolymerization initiator. Examples of the photopolymerization initiator include one or more selected from acetophenone, benzophenone, α-hydroxyalkylphenone, Michler's ketone, benzoin, benzyl methyl ketal, benzoyl benzoate, α-acyloxime ester, and thioxanthones.

Particles

The particles may be inorganic particles or organic particles.

Examples of the inorganic particles include silica particles, titanium dioxide particles, zirconia particles, aluminum oxide particles, diamond powder, sapphire particles, boron carbide particles, silicon carbide particles, and antimony pentoxide particles. Examples of the organic particles include resin particles of an acrylic resin, an acrylic-styrene copolymer, and a silicone resin. Among them, inorganic particles are preferable, and silica particles are more preferable, from the viewpoint that the transparency of the hard coat layer is hardly impaired. The surface of the inorganic particles may be treated with a surface modifier such as a silane coupling agent.

An average primary particle size of the particles is preferably 10 nm or more and 200 nm or less, and more preferably 30 nm or more and 100 nm or less. When the average primary particle size of the particles is set in the above range, Rz of the surface of the hard coat layer can be adjusted in the above range.

The average primary particle size of the particles in the hard coat layer can be measured by observing 10 points on the surface of the hard coat layer with a scanning electron microscope (SEM) at an acceleration voltage of 2.0 kV and a magnification of 50000 times, and averaging the observed values. Note that diameters of 10 random particles can be determined by measuring an area of each particle, calculating a diameter corresponding to a circle having the area, and calculating an arithmetic average value of the diameters of the particles as the average primary particle size.

The content of the particles in the hard coat layer is preferably 3 mass% or more and 80 mass% or less, and more preferably 6 mass% or more and 70 mass% or less, with respect to the curable composition. When the content of the particles is 3 mass% or more, Rz of the surface of the hard coat layer is more likely to be increased, and the anti-blocking property is more likely to be enhanced. When the content of the particles is 80 mass% or less, a decrease in transparency due to an increase in haze can be further suppressed.

The thickness of the hard coat layer is preferably 300 nm or more and 3000 nm or less. When the thickness of the hard coat layer is 300 nm or more, the scratch resistance of the laminated piezoelectric body is more easily enhanced. When the thickness of the hard coat layer is 3000 nm or less, the surface resistivity of the laminated piezoelectric body can be further reduced, and thus a higher antistatic property is easily achieved. From the same viewpoint, the thickness of the surface of the hard coat layer is more preferably 500 nm or more and 1500 nm or less, and still more preferably 700 nm or more and 1200 nm or less.

In addition, from the viewpoint of easily adjusting the surface resistivity of the laminated piezoelectric body in the range described above, a ratio (T2/T1) of the thickness (T2) of the hard coat layer to the thickness (T1) of the antistatic layer can be, for example, from 3 to 26, although the ratio also depends on the surface resistivity of the antistatic layer. As the ratio is smaller, the hard coat layer is thinner and the antistatic layer is thicker, and thus the surface resistivity measured on the hard coat layer can be further reduced.

Note that the thickness of each layer constituting the laminated piezoelectric body can be measured using a spectral interference-type thickness meter (for example, "Optical NanoGauge C13027-11" available from Hamamatsu Photonics K.K.). A refractive index of each layer can be measured by the method described in JIS K7142, and for example, the refractive indices of the base material and the coating film are set to 1.42 and 1.50, respectively. A thickness of each layer in a range including the center of the surface of the laminated piezoelectric body is measured at three or more points at 5 mm intervals, and the arithmetic average value thereof can be obtained as the thickness of each layer.

1-4. Layer Configuration

Each of the antistatic layer and the hard coat layer included in the laminated piezoelectric body may be one layer or include two or more layers. The laminated piezoelectric body may further include another layer in addition to the above layers. However, from the viewpoint of easily obtaining a high antistatic property, the antistatic layer and the hard coat layer are preferably in contact with each other.

For example, the laminated piezoelectric body can have the following layer configuration.

Piezoelectric film/antistatic layer/hard coat layer

Hard coat layer/piezoelectric film/antistatic layer/hard coat layer

1-5. Physical Properties

Surface Resistivity

The laminated piezoelectric body according to the present embodiment includes the antistatic layer, and thus the surface resistivity is reduced. Specifically, the surface resistivity measured on the hard coat layer of the laminated piezoelectric body is $1.0 \times 10^6$ Ω/sq. or more and $1.0 \times 10^{12}$ Ω/sq. or less. When the surface resistivity of the laminated piezoelectric body is $1.0 \times 10^{12}$ Ω/sq. or less, a sufficient antistatic property is likely to be obtained. When the surface resistivity of the laminated piezoelectric body is $1.0 \times 10^6$ Ω/sq. or more, unintended electrostatic discharge is more likely to be suppressed. From the same viewpoint, the surface resistivity of the laminated piezoelectric body is more preferably $1.0 \times 10^8$ Ω/sq. or more and $5.0 \times 10^{11}$ Ω/sq. or less. The surface resistivity of the laminated piezoelectric body can be measured by the same method as that for the surface resistivity of the antistatic layer.

The surface resistivity of the laminated piezoelectric body can be adjusted mainly by the surface resistivity of the antistatic layer and the thickness of the hard coat layer. When the surface resistivity of the antistatic layer is decreased and the thickness of the hard coat layer is decreased, the surface resistivity of the laminated piezoelectric body is likely to be decreased.

Total Light Transmittance

The laminated piezoelectric body preferably has high transparency from the viewpoint of being applied to a touch panel mounted on an image display device. Specifically, the total light transmittance of the laminated piezoelectric body is preferably 85% or more, and more preferably 90% or more.

The total light transmittance of the laminated piezoelectric body can be measured using a haze meter (for example, "NDH7000SP II", available from Nippon Denshoku Industries Co., Ltd.) based on the method described in JIS K 7361-1.

The total light transmittance of the laminated piezoelectric body can be adjusted by the thickness of the antistatic layer and the average particle size of the particles contained in the hard coat layer. For example, when the thickness of the antistatic layer is reduced, coating irregularities are less likely to occur, and the total light transmittance is likely to be higher. In addition, when the average particle size of the particles in the hard coat layer is decreased, the total light transmittance is likely to be further increased.

Piezoelectric Constant of Laminated Piezoelectric Body

The piezoelectric constant $d_{33}$ of the laminated piezoelectric body is adjusted to be 7 pC/N or more and 40 pC/N or less. When the piezoelectric constant $d_{33}$ of the laminated piezoelectric body is 7 pC/N or more, the amount of charge to be generated by the piezoelectric effect is sufficient, and thus high pressure sensitivity is likely to be achieved. When the piezoelectric constant $d_{33}$ of the laminated piezoelectric body is 40 pC/N or less, it is possible to further reduce irregularities of the film surface caused by, for example, the polarization treatment, and thus to reduce poor appearance. From the same viewpoint, the piezoelectric constant $d_{33}$ of the laminated piezoelectric body is more preferably 10 pC/N or more and 40 pC/N or less, still more preferably 10 pC/N or more and 27 pC/N or less, and particularly preferably 13 pC/N or more and 24 pC/N or less.

The piezoelectric constant $d_{33}$ of the laminated piezoelectric body can be adjusted mainly by the piezoelectric constant $d_{33}$ of the piezoelectric film. When the piezoelectric constant $d_{33}$ of the piezoelectric film is high, the piezoelectric constant $d_{33}$ of the laminated piezoelectric body is also likely to be high.

1-6. Effects

The laminated piezoelectric body according to the embodiment includes the piezoelectric film having a piezoelectric constant $d_{33}$ equal to or greater than a predetermined value, and thus has high piezoelectricity.
The laminated piezoelectric body has the laminated structure of the antistatic layer and the hard coat layer having Rz equal to or greater than a predetermined value, and the surface resistivity of the hard coat layer of the laminated piezoelectric body is adjusted to be equal to or less than a predetermined value. This makes it possible to achieve both the antistatic property and the anti-blocking property.
In addition, the thickness of the antistatic layer is adjusted to be equal to or less than a predetermined value. This reduces coating unevenness of the antistatic layer due to irregularities of the surface of the piezoelectric film containing the fluorine-based resin, thereby suppressing coating irregularities due to the coating unevenness. Thus, it is possible to suppress the reduction in visibility.

2. Method for Producing Laminated Piezoelectric Body

The laminated piezoelectric body according to the present embodiment can be produced through (1) preparing a piezoelectric film containing a fluorine-based resin, (2) applying an antistatic material onto at least one surface of the prepared piezoelectric film and then drying the antistatic material to form an antistatic layer, and (3) applying a curable resin composition onto the antistatic layer and then curing the curable resin composition to form a hard coat layer. Note that the piezoelectric film, the antistatic layer, and the hard coat layer are the piezoelectric film, the antistatic layer, and the hard coat layer described above, respectively.

(1) Preparing Piezoelectric Film

The piezoelectric film containing a fluorine-based resin may be a commercially available product or may be produced.

In a case where a piezoelectric film containing a fluorine-based resin is produced, the piezoelectric film can be obtained by subjecting a film containing a fluorine-based resin to a polarization treatment. The film containing a fluorine-based resin may be a stretched film or an unstretched film. In the present embodiment, from the viewpoint of exhibiting a high piezoelectric effect, it is preferable to stretch the film containing a fluorine-based resin and then subject the stretched film to the polarization treatment.

The film containing a fluorine-based resin can be produced by any method such as a melt-extrusion method (extrusion molding method) or a solution-casting method. Among them, from the viewpoint of easily obtaining a piezoelectric film having a thickness equal to or greater than a predetermined value, it is preferable that the film containing a fluorine-based resin is produced by the melt-extrusion method. In the melt-extrusion method, the fluorine-based resin and an additive of any type can be heated and melted in a cylinder of an extruder and then extruded from a die to obtain a film.

The obtained film has a structure in which an $\alpha$-type crystal (the main chain has a helical structure) and a $\beta$-type crystal (the main chain has a planar zigzag structure) are mixed. The $\beta$-type crystal has a large polarization structure. When the film is stretched, the $\alpha$-type crystal can be converted into the $\beta$-type crystal. During stretching, the film is preferably stretched as necessary to convert the fluorine-based resin into the $\beta$-type crystal. The stretching direction may be a TD direction or an MD direction, and is more preferably the MD direction.

The stretching method is not particularly limited, and can be performed by a known stretching method such as a tenter method or a drum method.

A stretching ratio is, for example, 3.0 or more times and 6.0 or less times. When the stretching ratio is 3.0 or more times, it is easy to adjust the thickness and polarizability of the film to more appropriate ranges. When the stretching ratio is 3.0 or more times, dislocation of the $\beta$-type crystals sufficiently proceeds, and not only higher piezoelectricity is likely to be exhibited but also transparency can be further enhanced. When the stretching ratio is 6.0 or less times, it is possible to further suppress breakage due to stretching.

The obtained stretched film is subjected to a polarization treatment. The polarization treatment can be performed by, for example, applying a DC voltage between a ground electrode and a needle-shaped electrode. The voltage may be adjusted depending on the thickness of the stretched film, and can be, for example, 1 kV or more and 50 kV or less.

As described above, in the present embodiment, the piezoelectric film can be obtained by subjecting the stretched film to the polarization treatment.

(2) Forming Antistatic Layer

For example, the curable composition containing the above-described conductive material is applied onto the obtained piezoelectric film, and then dried and cured to form an antistatic layer.

The antistatic material may further contain water or a solvent. Examples of the solvent include alcohol-based solvents such as methanol, ethanol, and isopropyl alcohol.

The application method is not particularly limited, and may be any of a spin coating method, a gravure coating method, a die coating method, a bar coating method, a dip coating method, and the like.

The drying method is a method of heating the applied antistatic material. The heating temperature is preferably a temperature equal to or higher than a temperature at which the solvent can be removed and equal to or lower than a thermal deformation temperature of the fluorine-based resin constituting the piezoelectric film, and can be set to, for example, 100°C or higher and 150°C or lower. The thermal deformation temperature can be measured, for example, in accordance with JIS K 7191-2:2015.

(3) Forming Hard Coat Layer

A coating liquid containing the curable composition described above is applied onto the obtained antistatic layer, and then dried and cured to form a hard coat layer.

The coating liquid may further contain a diluting solvent as necessary. As the diluting solvent, a solvent having a polarity close to that of the particles is preferable. Examples of the diluting solvent include organic solvents such as an alcohol-based solvent, a ketone-based solvent, an ester-based solvent, a carbonate-based solvent, and an aromatic solvent.

The application of the coating liquid can be performed by the same method as the application method described above. The drying of the coating liquid can be performed by the same method as the drying method described above. Note that the heating temperature may be a temperature equal to or lower than the thermal deformation temperature of the fluorine-based resin constituting the piezoelectric film within a range in which the solvent can be volatilized and removed, and can be, for example, 60°C or higher and 100°C or lower.

The curing may be performed by heat or by ionizing radiation. The curing by ionizing radiation can be performed by irradiation with ultraviolet light or an electron beam. Curing by heat and curing by ionizing radiation may be used in combination.

3. Applications

The laminated piezoelectric body according to the present embodiment can be used for various applications. In particular, the laminated piezoelectric body according to the present embodiment exhibits high piezoelectricity while having high transparency and visibility, and thus can be preferably used as a pressure-sensitive sensor of a touch panel mounted on various electronic devices.

Examples

Hereinafter, the present invention will be further described with reference to Examples and Comparative Examples. The technical scope of the present invention is not limited to these.

1. Evaluation of Physical Properties

(1) Layer Thickness

The thickness of each layer was measured using a spectral interference-type thickness meter ("Optical NanoGauge C13027-11" available from Hamamatsu Photonics K.K.). The thickness of each layer in a range including the center of the surface of the laminated piezoelectric body was measured at 30 points at 5 mm intervals, and the arithmetic average value thereof was calculated. Note that the refractive index of each layer was set for each material of each layer, and was set to 1.42 for the piezoelectric film containing PVDF, 1.50 for the antistatic layer, and 1.50 for the hard coat layer.

(2) Particle Size

The surface of the hard coat layer of the laminated piezoelectric body was observed using a scanning electron microscope ("SU3800", available from Hitachi High-Technologies Corporation) under the conditions of an acceleration voltage of 2.0 kV and a magnification of 50000 times. The measurement was performed at 10 points and the average thereof was taken as the particle size of the inorganic nanoparticles.

(3) Piezoelectric Constant

Piezoelectric Constant $d_{33}$

The piezoelectric constant $d_{33}$ was measured in accordance with ISO 19622:2018, which is a test method for the piezoelectric constant $d_{33}$ of piezoelectric ceramics by a direct quasi-static method ($d_{33}$ meter method, Berlincourt method). Specifically, the piezoelectric constant $d_{33}$ of the laminated piezoelectric body was measured by using a piezoelectric constant measuring device ("PiezoMeter System PM300", available from PIEZOTEST Pte Ltd) by clipping a sample at 1 N and reading the generated charge when a force of 0.15 N and 110 Hz was applied. The actual measurement value of the piezoelectric constant $d_{33}$ at a measurement temperature of 25°C is a positive value or a negative value, depending on whether the front or back side of the film is measured. However, the absolute value is described in the present specification.

$d_{14}$

Al was deposited on both surfaces of the laminated piezoelectric body, and the laminated piezoelectric body was cut to 120 mm in a direction of 45° with respect to the stretching direction (MD direction) of the piezoelectric film and to 10 mm in a direction orthogonal to the direction of 45°, thereby cutting out a rectangular film of 120 mm × 10 mm. This was used as a sample for measurement.

Then, the sample was set in a tensile tester with a chuck-to-chuck distance of 70 mm not to sag. Then, a force was periodically applied to the sample at a rate of 5 mm/min in such a manner that the applied force alternated between 4 N and 9 N. To measure a charge amount generated in the sample in response to the applied force at this time, a capacitor having a capacitance Qm (F) was connected in parallel to the sample, and an inter-terminal voltage Vm of the capacitor Cm (95 nF) was measured via a buffer amplifier. The generated charge amount Q (C) was calculated as the product of the capacitor capacitance Cm and the inter-terminal voltage Vm. The piezoelectric constant $d_{14}$ was calculated by the following equation.

$$d_{14} = (2 \times t)/L \times Cm \cdot \Delta Vm/\Delta F$$

t: Sample thickness (m)
L: Chuck-to-chuck distance (m)
Cm: Capacitance of parallel-connected capacitor (F)
$\Delta Vm/\Delta F$: Ratio of the amount of change in voltage between the terminals of the capacitor to the amount of change in force

2. Preparation and Evaluation of Laminated Piezoelectric Body

Example 1

(1) Preparation of Piezoelectric Film

After stretching a polyvinylidene fluoride film (available from KUREHA CORPORATION, film containing 100 mass% of a vinylidene fluoride homopolymer) in the MD direction to a stretching ratio of 4.2 times, the film was subjected to the polarization treatment by applying a DC voltage between a ground electrode and a needle-shaped electrode while the DC voltage was increased from 0 kV to 11.0 kV to obtain a piezoelectric film having a thickness of 42 $\mu$m. The piezoelectric constant $d_{33}$ of the piezoelectric film was measured by the above method and found to be 15 pC/N.

(2) Formation of Antistatic Layer

A mixed solution of a coating material P-400MP-A (available from Nagase ChemteX Corporation) containing PEDOT:PSS as a conductive polymer and a coating material P-400MP-B (available from Nagase ChemteX Corporation) containing a crosslinking agent and a conductivity improver at a ratio of 4 : 1 was applied to an A surface of the obtained piezoelectric film by a multicoater (available from Hirano Tecseed Co., Ltd.), and the resultant was subjected to a heat treatment at 130°C for 0.67 minutes to form an antistatic layer having a thickness of 50 nm on the piezoelectric film.

(3) Formation of Hard Coat Layer

Then, a hard coating agent (BS-CH271 available from Arakawa Chemical Industries, Ltd., average particle size of amorphous silica: 60 nm) was applied onto the antistatic layer by a multicoater, and the resultant was then subjected to a heat treatment at 80°C for 2 minutes, and further irradiated with UV at an integrated light quantity of 200 mJ/cm$^2$ to be photocured, thereby forming a hard coat layer having a thickness of 700 nm. Thus, a laminated piezoelectric body having a laminated structure of piezoelectric film/antistatic layer/hard coat layer was obtained.

[Example 2]

A laminated piezoelectric body was obtained in the same manner as in Example 1, except that the thickness of the hard coat layer was changed to 2000 nm.

[Example 3]

A laminated piezoelectric body was obtained in the same manner as in Example 1, except that the thickness of the antistatic layer was 140 nm.

[Example 4]

A laminated piezoelectric body was obtained in the same manner as in Example 1, except that the heat treatment conditions when forming the antistatic layer were changed to 120°C for 60 minutes.

[Example 5]

A laminated piezoelectric body was obtained in the same manner as in Example 1, except that a mixed solution (C-169PF) of a coating material C-169PF-A (available from Nagase ChemteX Corporation) containing single-walled carbon nanotubes and a coating material C-169PF-B (available from Nagase ChemteX Corporation) containing a crosslinking agent at a ratio of 3 : 2 was applied onto the A surface of the piezoelectric film by a multicoater (available from Hirano Tecseed Co., Ltd.), and the resultant was subjected to a heat treatment at 130°C for 1 minute to form an antistatic layer.

[Example 6]

A hard coat layer having a thickness of 700 nm was further formed on a B surface of the piezoelectric film of the laminated piezoelectric body prepared in Example 1 in the same manner as in Example 1, thereby obtaining a laminated piezoelectric body. Thus, a laminated piezoelectric body having a laminated structure of hard coat layer/piezoelectric film/antistatic layer/hard coat layer was obtained.

[Example 7]

A laminated piezoelectric body was obtained in the same manner as in Example 1, except that the hard coating agent was changed to TYAB-M101 (average particle size of amorphous silica: 80 nm) available from Toyochem Co., Ltd.

[Comparative Example 1]

Neither an antistatic layer nor a hard coat layer was formed, and the piezoelectric film of Example 1 was used as it was.

[Comparative Example 2]

A laminated piezoelectric body was obtained in the same manner as in Example 1, except that the hard coating agent containing amorphous silica was changed to a hard coating agent (BS-575, available from Arakawa Chemical Industries, Ltd.) containing no amorphous silica.

[Comparative Example 3]

A laminated piezoelectric body was obtained in the same manner as in Example 1, except that the thickness of the antistatic layer was changed to 5 nm.

[Comparative Example 4]

A laminated piezoelectric body was obtained in the same manner as in Example 1, except that the thickness of the antistatic layer was changed to 260 nm.

[Comparative Example 5]

An antistatic layer was formed in the same manner as in Example 1, except that the heat treatment conditions at the time of forming the antistatic layer were changed to 160°C for 60 minutes. However, appearance of the laminated piezoelectric body was poor, and the hard coat layer was not formed.

[Comparative Example 6]

An attempt was made to form an antistatic layer in the same manner as in Example 1, except that the heat treatment conditions at the time of forming the antistatic layer were changed to 80°C for 0.67 minutes, but curing of the antistatic layer was insufficient, and the hard coat layer was not formed.

Comparative Example 7

An antistatic hard coating agent (MT-3, available from Arakawa Chemical Industries, Ltd.) was applied onto the piezoelectric film of Example 1 with a multicoater, and the resultant was subjected to a heat treatment at 80°C for 2 minutes, and then irradiated with UV at an integrated light quantity of 400 mJ/cm$^2$ using a UV irradiator CSOT-40 (available from GS Yuasa Corporation) to obtain a laminated piezoelectric body. Thus, a laminated piezoelectric body having a laminated structure of piezoelectric film/antistatic hard coat layer was obtained.

[Comparative Example 8]

(1) Preparation of Piezoelectric Film Containing Polylactic Acid

To 100 parts by mass of polylactic acid (product name: Ingeo (trade name) biopolymer) available from Nature-Works LLC, 1.0 part by mass of a stabilizer [a mixture of Stabaxol P400 (10 parts by mass) available from Rhein Chemie, Stabaxol I (70 parts by mass) available from Rhein Chemie, and Carbodilite LA-1 (20 parts by mass) available from Nisshinbo Chemical Inc.] was added, and the mixture was dry-blended to adjust a raw material.
Then, the raw material was put into a hopper of an extruder, extruded from a T-die while heating at 210°C, and brought into contact with a cast roll at 50°C to form a pre-crystallized film having a thickness of 150 μm. The pre-crystallized film was uniaxially stretched in the MD direction to a stretching ratio of 3.5 times at 70°C by a roll-to-roll method to obtain a uniaxially stretched film. The obtained uniaxially stretched film had a thickness of 49.2 μm.
The obtained uniaxially stretched film was brought into contact with a roll at 145°C for 15 seconds by a roll-to-roll method to be annealed, and then quenched to prepare a piezoelectric film containing polylactic acid. The piezoelectric constant $d_{14}$ of the piezoelectric film was measured by the above method and found to be 6 pC/N.

(2) Formation of Antistatic Hard Coat Layer

An antistatic hard coat coating material (SEPULZIDA (trade name) HC-A, available from Shin-Etsu Polymer Co., Ltd.) was applied onto one surface of the obtained piezoelectric film with a multicoater, and the resultant was dried at 60°C for 5 minutes, and then irradiated with ultraviolet light at an integrated light quantity of 1000 mJ/cm$^2$ with a metal halide lamp to form an antistatic hard coat layer. Thus, a laminated piezoelectric body having a laminated structure of piezoelectric film/antistatic hard coat layer was obtained.

Evaluation

The surface resistivity, charge amount, blocking resistance, surface maximum height Rz, and total light transmittance of the obtained laminated piezoelectric bodies were evaluated by the following methods.

(1) Surface Resistivity

Each of the laminated piezoelectric bodies or the piezoelectric films was cut into a size of 100 mm × 100 mm to obtain a sample. The surface resistivity of the hard coat layer of the sample was measured using a surface resistance meter F-109 (available from Hozan Co., Ltd.) in accordance with JIS 6911. As the measuring conditions, a value was read after 10 seconds at a power of 100 W.

(2) Charge Amount

For each of the films in wound states (film roll), the surface potential (kV) of the film was measured by using an electrostatic potential measuring device (SK-H050, available from Keyence Corporation). The measurement was performed at a position 10 cm from the film surface of the outside of the roll.

(3) Blocking Resistance

Two test pieces each having a size of 10 cm long × 10 cm wide were cut out from the laminated piezoelectric body or the piezoelectric film, the hard coat surface of one of the two test pieces and the hard coat surface of the other were overlapped, and the degree of sticking when the films were rubbed with each other was visually confirmed and evaluated according to the following criteria.

∘: No sticking
×: With sticking

---

**EP 4 691 758 A1**

(4) Maximum Height Rz

The maximum height Rz of the surface of the hard coat layer of each of the laminated piezoelectric bodies was measured by a method in accordance with JIS B 0601-2013 using a surface roughness measuring instrument ("SURFCOM 1500", available from TOKYO SEIMITSU CO., LTD.). The maximum height Rz was measured in the width direction (TD direction) of the laminated piezoelectric film at 10 random points on the hard coat layer, and the average value thereof was determined.

(5) Total Light Transmittance

The total light transmittance of each of the laminated piezoelectric bodies was measured using a haze meter ("NDH7000SP II", available from Nippon Denshoku Industries Co., Ltd.) based on the method described in JIS K 7361-1.

(6) Color Unevenness

Whether or not the color unevenness of each of the laminated piezoelectric bodies was visually recognized along the MD direction was evaluated according to the following criteria.

○: No color unevenness is visually recognized

×: Color unevenness is visually recognized

(7) Piezoelectric Constant of Laminated Piezoelectric Body

The piezoelectric constant $d_{33}$ or $d_{14}$ of each of the laminated piezoelectric bodies was measured by the same method as described above.
The production conditions and layer configurations of the laminated piezoelectric bodies of Examples 1 to 7 and Comparative Examples 1 to 8 are shown in Table 1. Among them, the evaluation results for the laminated piezoelectric bodies of Examples 1 to 7 and Comparative Examples 2 to 4 and 7 are shown in Table 2.

**14**

EP 4 691 758 A1

[Table 1]

| | Piezoelectric film raw material | Antistatic layer | | | hard coat layer | | | | |
|---|---|---|---|---|---|---|---|---|---|
| | | Heat treatment | | Film thickness/nm | Heat treatment | | UV irradiation amount/mJ/cm$^2$ | Inorganic particle size/nm | Film thickness/nm |
| | | Temperature/°C | Time/min | | Temperature/°C | Time/min | | | |
| Example 1 | PVDF | 130 | 0.67 | 50 | 80 | 2 | 200 | 60 | 700 |
| Example 2 | PVDF | 130 | 0.67 | 50 | 80 | 2 | 200 | 60 | 2000 |
| Example 3 | PVDF | 130 | 0.67 | 140 | 80 | 2 | 200 | 60 | 700 |
| Example 4 | PVDF | 120 | 60 | 50 | 80 | 2 | 200 | 60 | 700 |
| Example 5 | PVDF | 130 | 0.67 | 50 | 80 | 2 | 200 | 60 | 700 |
| Example 6 | PVDF | 130 | 0.67 | 50 | 80 | 2 | 200 | 60 | 700 |
| Example 7 | PVDF | 130 | 0.67 | 50 | 80 | 2 | 200 | 80 | 700 |
| Comparative Example 1 | PVDF | - | - | - | - | - | - | - | - |
| Comparative Example 2 | PVDF | 130 | 0.67 | 50 | 80 | 2 | 200 | - | 700 |
| Comparative Example 3 | PVDF | 130 | 0.67 | 5 | 80 | 2 | 200 | 60 | 700 |
| Comparative Example 4 | PVDF | 130 | 0.67 | 260 | 80 | 2 | 200 | 60 | 700 |
| Comparative Example 5 | PVDF | 160 | 60 | 50 | - | - | - | - | - |
| Comparative Example 6 | PVDF | 80 | 0.67 | 50 | - | - | - | - | - |
| Comparative Example 7 | PVDF | - | - | - | 80 | 2 | 200 | - | 700 |
| Comparative Example 8 | PLA | - | - | - | 60 | 5 | 1000 | - | 4000 |

[Table 2]

| | Surface resistance va-lue/$\Omega$/sq. | Charge amount/kV | Blocking resistance | Surface maximum height Rz/nm | Total light transmittance/% | Color unevenness | Piezoelectric constant $d_{33}$/pC/N |
|---|---|---|---|---|---|---|---|
| Example 1 | $1.1 \times 10^{10}$ | 0.2 kV | ○ | 53 | 92.7 | ○ | 14 |
| Example 2 | $3.1 \times 10^{10}$ | 0.2 kV | ○ | 54 | 92.7 | | 14 |
| Example 3 | $1.2 \times 10^{8}$ | 0.2 kV | ○ | 53 | 91.4 | ○ | 14 |
| Example 4 | $1.0 \times 10^{10}$ | 0.2 kV | ○ | 57 | 92.7 | ○ ○ | 14 |
| Example 5 | $4.2 \times 10^{8}$ | 0.1 kV | ○ | 57 | 90.8 | ○ | 14 |
| Example 6 | $1.1 \times 10^{10}$ | 0.2 kV | ○ | 53 | 91.9 | ○ | 13 |
| Example 7 | $1.1 \times 10^{10}$ | 0.1 kV | ○ | 52 | 91.9 | ○ | 14 |
| Comparative Example 1 | $1.0 \times 10^{14}$ or more | -20 kV | × | 185 | 93.6 | - | 15 |
| Comparative Example 2 | $1.1 \times 10^{10}$ | 0.2 kV | × | 35 | 91.9 | ○ | 14 |
| Comparative Example 3 | $1.0 \times 1014$ or more | -20 kV | ○ | 57 | 92.7 | ○ | 14 |
| Comparative Example 4 | $8.6 \times 10^{7}$ | 0.0 kV | ○ | 57 | 89.8 | × | 14 |
| Comparative Example 5 | - | - | - | - | 88.9 | - | - |
| Comparative Example 6 | - | - | - | - | - | - | - |
| Comparative Example 7 | $2.1 \times 10^{10}$ | 0.5 kV | × | 35 | 92.7 | × | 14 |
| Comparative Example 8 | $3.1 \times 10^{10}$ | 0.0 kV | × | 33 | 91.1 | ○ | 6[*)] |

*) The piezoelectric constant of PLA is $d_{14}$, and thus the value of the piezoelectric constant $d_{14}$ is also shown for the laminated piezoelectric body using the PLA piezoelectric film.

As shown in Table 2, it is found that the laminated piezoelectric bodies of Comparative Examples 2 and 7 having a hard coat layer with Rz of less than 40 nm have poor blocking resistance. In addition, it is found that the piezoelectric film of Comparative Example 1 having no antistatic layer and the laminated piezoelectric body of Comparative Example 3 in which the antistatic layer has a thickness of less than 10 nm have high surface resistivity and a poor antistatic property. In addition, it is found that the laminated piezoelectric body of Comparative Example 4 in which the antistatic layer has a thickness of more than 250 nm exhibits a sufficient antistatic property, but color unevenness occurs. In addition, it is found that the piezoelectric constant of the laminated piezoelectric body of Comparative Example 8 using the piezoelectric film containing polylactic acid is low.

In contrast, it is found that the laminated piezoelectric bodies of Examples 1 to 7 all exhibit a high piezoelectric constant without causing color unevenness, and have high blocking resistance and a high antistatic property.

In particular, it is suggested that the surface resistivity is further decreased and the antistatic property is further enhanced by further decreasing the thickness of the hard coat layer (comparison between Examples 1 and 2).

In addition, it is found that the total light transmittance can be further increased by further reducing the thickness of the antistatic layer (comparison between Examples 1 and 3).

The present application claims priority from the Japanese Patent Application No. 2023-48031 filed on March 24, 2023. The contents described in the specification of the foregoing application are all incorporated in the specification of the present application by reference.

INDUSTRIAL APPLICABILITY

The laminated piezoelectric body of the present invention has high piezoelectricity, an anti-blocking property, and an antistatic property without reducing visibility. Accordingly, the laminated piezoelectric body can be suitably used as a pressure-sensitive sensor of a touch panel.

**Claims**

1. A laminated piezoelectric body comprising:

   a piezoelectric film containing a fluorine-based resin as a main component;
   an antistatic layer disposed on at least one surface of the piezoelectric film and having a thickness of 10 nm or more and 250 nm or less; and
   a hard coat layer disposed on the antistatic layer and having a maximum surface height Rz of 40 nm or more and 150 nm or less,
   the laminated piezoelectric body having
   a surface resistivity of $1.0 \times 10^6$ Ω/sq. or more and $1.0 \times 10^{12}$ Ω/sq. or less, the surface resistivity being measured on the hard coat layer,
   and the laminated piezoelectric body having a total light transmittance of 85% or more, and a piezoelectric constant $d_{33}$ of 7 pC/N or more and 40 pC/N or less.

2. The laminated piezoelectric body according to claim 1, wherein
   the fluorine-based resin is a polymer containing, as a main component, a structural unit derived from vinylidene fluoride.

3. The laminated piezoelectric body according to claim 1, wherein
   the fluorine-based resin is a vinylidene fluoride homopolymer.

4. The laminated piezoelectric body according to claim 1, wherein
   the antistatic layer contains a carbon nanotube.

5. The laminated piezoelectric body according to claim 1, wherein
   the hard coat layer has a thickness of 300 nm or more and 3000 nm or less.

6. The laminated piezoelectric body according to claim 1, wherein
   the hard coat layer contains silica particles having an average particle size of 10 nm or more and 200 nm or less.

7. A method for producing the laminated piezoelectric body described in claim 1, the method comprising:

   preparing a piezoelectric film containing a fluorine-based resin as a main component and having a piezoelectric constant $d_{33}$ of 7 pC/N or more and 40 pC/N or less;
   applying an antistatic material onto at least one surface of the piezoelectric film to form an antistatic layer; and
   applying a curable composition onto the antistatic layer and then curing the curable composition to form a hard coat layer.

8. The method for producing the laminated piezoelectric body according to claim 7, wherein

   in the preparing of the piezoelectric film,
   a film containing a fluorine-based resin as a main component is formed by extrusion molding.

9. The method for producing the laminated piezoelectric body according to claim 7, wherein

   in the preparing of the piezoelectric film,
   a film containing a fluorine-based resin as a main component is stretched, and then subjected to a polarization treatment.

10. The method for producing the laminated piezoelectric body according to claim 7, wherein

    in the forming of the antistatic layer,
    the piezoelectric film onto which the antistatic material is applied is dried by a heat treatment at 100°C or higher and 150°C or lower.

# EP 4 691 758 A1

## INTERNATIONAL SEARCH REPORT

| International application No. |
|---|
| **PCT/JP2024/010932** |

### A. CLASSIFICATION OF SUBJECT MATTER

***B32B 7/025***(2019.01)i; ***B32B 27/18***(2006.01)i; ***B32B 27/30***(2006.01)i; ***G02B 1/14***(2015.01)i; ***G02B 1/16***(2015.01)i; ***H10N 30/045***(2023.01)i; ***H10N 30/077***(2023.01)i; ***H10N 30/097***(2023.01)i; ***H10N 30/857***(2023.01)i
FI: B32B7/025; B32B27/18 D; B32B27/30 D; H10N30/857; H10N30/077; H10N30/045; H10N30/097; G02B1/16; G02B1/14

According to International Patent Classification (IPC) or to both national classification and IPC

### B. FIELDS SEARCHED

Minimum documentation searched (classification system followed by classification symbols)

B32B1/00-43/00; G02B1/14; G02B1/16; H10N30/045; H10N30/077; H10N30/097; H10N30/857; C08J7/04-7/06; C08L27/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/091828 A1 (KUREHA CORP.) 05 May 2022 (2022-05-05) entire text | 1-10 |
| A | WO 2019/102635 A1 (NITTO DENKO CORPORATION) 31 May 2019 (2019-05-31) whole document | 1-10 |
| P, A | WO 2023/067899 A1 (KUREHA CORP.) 27 April 2023 (2023-04-27) entire text | 1-10 |

☐ Further documents are listed in the continuation of Box C.  ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **15 May 2024** | **28 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

18

INTERNATIONAL SEARCH REPORT
Information on patent family members

International application No.

**PCT/JP2024/010932**

| Patent document cited in search report | | | Publication date (day/month/year) | Patent family member(s) | | | Publication date (day/month/year) |
|---|---|---|---|---|---|---|---|
| WO | 2022/091828 | A1 | 05 May 2022 | US | 2023/0397500 | A1 | |
| | | | | entire text | | | |
| | | | | EP | 4238763 | A1 | |
| | | | | CN | 116234701 | A | |
| | | | | KR | 10-2023-0074765 | A | |
| | | | | TW | 202218199 | A | |
| WO | 2019/102635 | A1 | 31 May 2019 | CN | 111386613 | A | |
| | | | | KR | 10-2020-0089257 | A | |
| WO | 2023/067899 | A1 | 27 April 2023 | TW | 202317370 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010026938 A
- WO 2016098597 A
- JP 2023048031 A